Europäisches Patentamt

European Patent Office

Office européen des brevets

(11) Publication number: **0 245 713 B1**

# EUROPEAN PATENT SPECIFICATION

(45) Date of publication of patent specification: 26.06.91  (51) Int. Cl.⁵: **H05K 3/34**

(21) Application number: **87106275.8**

(22) Date of filing: **30.04.87**

(54) **Solder pads for use on printed circuit boards.**

(30) Priority: **12.05.86 US 861815**

(43) Date of publication of application:
**19.11.87 Bulletin 87/47**

(45) Publication of the grant of the patent:
**26.06.91 Bulletin 91/26**

(84) Designated Contracting States:
**DE FR GB IT**

(56) References cited:
**WO-A-85/00085**
**US-A- 3 700 443**
**US-A- 4 091 529**
**US-A- 4 254 448**
**US-A- 4 515 304**

(73) Proprietor: **International Business Machines Corporation**
**Old Orchard Road**
**Armonk, N.Y. 10504(US)**

(72) Inventor: **Napp, Duane Theodor**
**11506 Pencewood Drive**
**Austin Texas 78750(US)**
Inventor: **Roche, Kevin Joseph**
**11213 Taterwood Drive**
**Austin Texas 78750(US)**

(74) Representative: **Burt, Roger James, Dr.**
**IBM United Kingdom Limited Intellectual**
**Property Department Hursley Park**
**Winchester Hampshire SO21 2JN(GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

# Description

The present invention relates to the design of solder pads for use on printed circuit boards. More specifically it relates to an improvement in self alignment characteristics of surface mountable components as a result of a particular solder pad geometry.

The electronic industry is moving rapidly from pin in hole component attachment techniques to printed circuit boards to surface connection techniques which are significantly different. Pin in hole components are inserted into holes in the printed circuit boards and the leads are clinched to temporarily hold the components during subsequent flux and solder operations.

Two processes are most frequently used in the industry for attaching surface mountable components to printed circuit boards. In the first technique solder paste or creams are applied to the printed circuit boards using stencils or screens. The paste is dried until tacky. Components are placed on the tacky solder paste and the reflow operation occurs in a vapour phase or infrared reflow machine. Using stencils and screens requires new artwork unique to each board configuration. This requirement is costly, time consuming and messy.

The other process includes mounting the components to the printed circuit board with adhesives then passing the assembled board over a wave of solder. Numerous problems such as solder bridges, non-wet areas, adhesive stringers, and frequency of rework requirements are inherent in this process.

US-A-4,515,304 to Burger exemplifies the direction taken in the industry. This reference teaches mounting of leaded components and surface mountable components on opposite sides of the same printed circuit board. It teaches a multi-step process including inserting the leaded components crimping their ends, turning the board over and applying solder paste using individual applicator nozzles to the ends of the leads and to solder pads on the circuit pattern. Surface mountable components are positioned with their contact areas aligned with the solder pads and the whole reflow soldered.

The aim of the present invention as claimed in claims 1, 4 and 9 is to provide a method for attaching surface mountable components to a printed circuit substrate which overcomes the aforementioned problems of high cost and low efficiency associated with the prior art.

According to Claim 1 of the present invention, there is now provided a method of attaching leaded surface mountable components to surface solder pads on a printed circuit substrate comprising metalising the solder pads; depositing solder on the metalised solder pads; placing the components on the solder; reflowing the solder; characterised in that the metalising step comprises dividing each solder pad into a plurality of sections; metalising non-adjacent ones of said sections for enabling self alignment of the components to the solder pads during the reflowing step. During the depositing step, solder is deposited only on the metalised non adjacent sections. The deposited solder is dome-like in cross-section. The presence of domes on the metalised section of each solder pad causes the component placed thereon to self centre due to the configuration of its leads. This has the advantage that the geometry of the solder pads provides a component self alignment capability thereby increasing the reliability of the resulting electrical connections and process yield. Furthermore, conventional wave solder apparatus apparatus may be used to deposit the solder on the printed substrate.

Solder pads may be divided in the x or y direction. The x direction pads allow the component to float in the y direction, but centres it in the x direction while the y direction pads centre the component in the y direction allowing the component to float in the x direction. Best fit of all component leads to the pads is obtained during solder reflow.

One way of carrying out the invention is described in detail below with reference to drawings which illustrate only one specific embodiment, in which:

Figure 1 is a planar view of a solder pad divided in accordance with the invention;

Figure 2 is a cross-sectional view of a solder pad with solder applied;

Figure 3 illustrates the position of component leads relative to the soldered pads;

Figure 4 illustrates a plurality of solder pads divided in accordance with the invention in both the x and y directions; and

Figures 5, 6 and 7 illustrate alternative pad geometry embodiments.

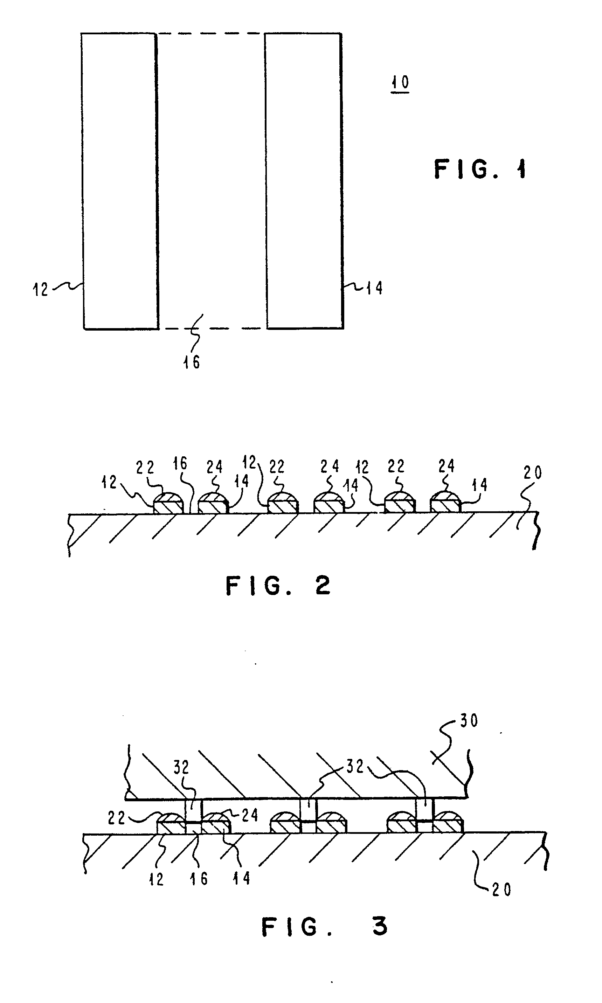

Fig. 1 shows, not to scale, a schematic representation of a solder pad 10 on the surface of a printed circuit substrate. Solder pad 10 is generally rectangular. In accordance with the invention, pad 10 is divided into three areas, 12 and 14 are metalised areas to which solder will be applied. The area 16 between portions 12 and 14 is not metalised and is not solder wettable.

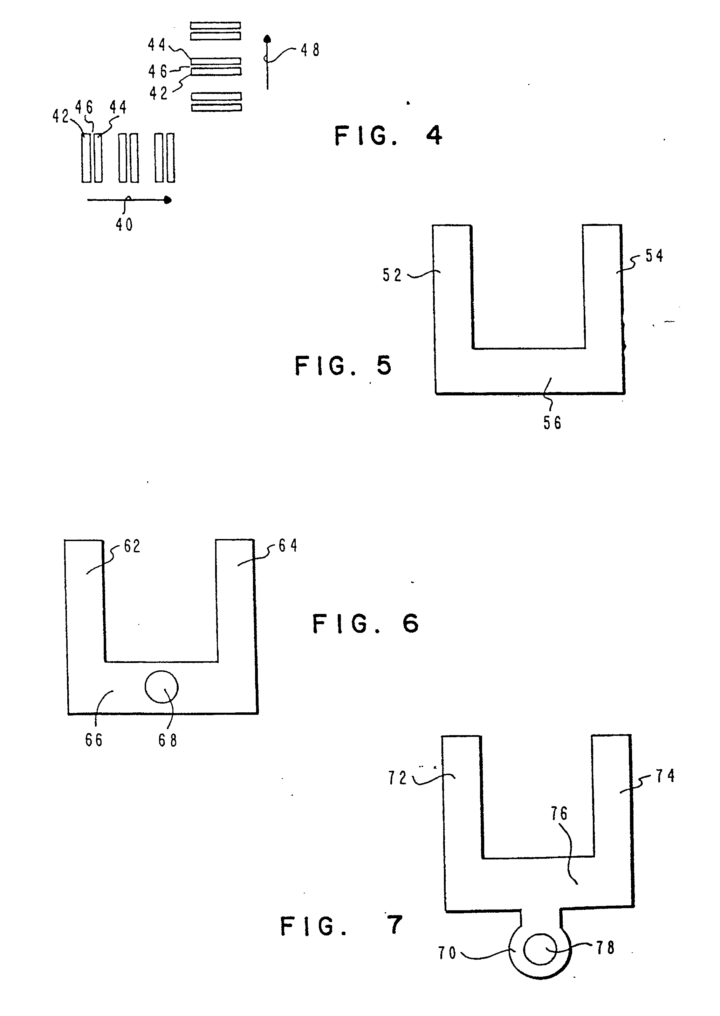

In the Figs. 2 and 3, the areas 12, 14 and 16 are also shown in cross-section. Referring specifically to Fig. 2, a portion of a printed circuit substrate 20 is shown with metalised solder pad areas 12 and 14 for three solder pads. Each metalised pad area 12 and 14 has solder applied thereto. Due to the physical properties of solder applied through wave soldering, domed solder areas 22 and 24 are formed.

Fig. 3 schematically represents in cross-section the printed circuit substrate 20 with solder pads 22 and 24 and a component 30 with leads 32 located so that each lead 32 fits between a set of solder domes 22 and 24. It will be appreciated that as the component 30 is lowered toward circuit substrate 20, that leads 32 if not exactly centred between solder domes 22 and 24 will by virtue of the geometry of the dome and lead tend to self centre between the domes.

Refer back to Fig. 1. The total width of the usual solder pad falls in the range from about 610 to 864 $\mu$m (24 to 34 mils). It has been found that dividing it into three sections 12, 14, and 16 as shown in Fig. 1. Only sections 12 and 14 which have a width in a range from about 9 to 15 mils are metalised, typically copper plated, and the section 16 between the metalised pads is generally in the range of about 101 to 152 $\mu$m (4 to 6 mils) wide and is not metalised, but may typically be glass epoxy. When a printed circuit card having such pad configurations is passed over a solder wave, solder is deposited of course only on metalised areas 12 and 14 and the cross-section of the soldered pads has the configuration shown in Figs. 2 and 3.

Refer now to Fig. 4. A corner section of a generally rectangular land pattern on a printed circuit substrate is shown. Arrow 40 represents the x direction and arrow 48 represents the y direction. Two sets of three solder pads are represented, only two of which have reference numerals. Areas 42 and 44 represent the metalised portions of the solder pad (compare to 12 and 14, Fig. 1). An area 46 represents the non-metalised area equivalent to section 16 in Fig. 1. The three pads in the y direction shown by arrow 48 are similarly indicated.

It will be appreciated by those skilled in the art that arranging the metalisation pattern to have the metalised areas with their lengthwise dimension generally perpendicular to the x or y direction of the surface allows an enhancement to the component self centring effect already described. During the solder reflow step of the entire component attach process the x direction pads, indicated as those perpendicular to arrow 40, allow the component to "float" in the y direction, but it centres itself in the x direction. Similarly, the y direction pads, those perpendicular to arrow 48, allow the component leads to "float" in the x direction while centring in the y direction. The best fit of all component leads to the pads is obtained during the reflow phase of the operation.

The advantage of the self centring property of components mounted to pads metalised in accordance with the present invention, is appreciated with the improved reliability of the solder joints and the reduction in rework requirements. All leads have a maximum area of contact with the solder pads and the accuracy of component placement enhanced by the self centring property decreases rework steps. Further advantages accrue from the lessening of assembly costs due to the elimination of the materials and apparatus associated with the application of solder paste, generation of the artwork, and manufacture of stencils.

Figs. 5, 6 and 7 represent alternative pad geometries which have been found to display the same advantageous component self centring features. In Fig. 5 the pad is metalised in a generally U-shaped configuration with upright arms 52, 54 and base 56 serving to capture and hold the component lead.

While the several figures represent only the planar dimensions, it will be understood that, as represented in Figs. 2 and 3, a certain thickness of solder pad is present. The required thickness is a function of the length of the component leads. A metalised layer having a thickness in the range of about 152,4 $\mu$m (6 mils) greater than the length of the component has been found to be particularly effective. As is true of portions 12 and 14 in Fig. 1, as well, upright arms 52 and 54 have been found to be most effective when their width is substantially equal to a value no greater than half the width of the component lead minus 50,8 $\mu$m (2 mils). The non-metalised area between upright arms 52 and 54 is chosen in a manner similar to the width of the area 16 in Fig. 1, advantageously, in the range between 4 mils and up to half the component lead width.

Fig. 6 represents another satisfactory metalisation pattern in which the areas represented by 62, 64 and 66 are equivalent to 52, 54, and 56 in Fig. 5. A through hole 68, however, is added in the base of the U-shaped 66 in Fig. 6. This through hole provides a electrical access means from the opposite surface of the printed circuit substrate so that test readings may be obtained as desired. In addition this though hole can be used for z-axis escape for the wiring of the printed circuit board.

Fig. 7 differs from Fig. 6 in the overall configuration by having a area 70 extending from the general U-shaped portion in which section 72, 74, and 76 are equivalent to sections 62, 64 and 66 discussed with reference to Fig. 6. Metalised extension area 70 may also include a through hole 78. The dimensions for extension 70 and hole 78 are not critical as they are provided for electrical access, both from the surface on which the metalised solder pad is located and from the rear or opposite side of the printed circuit substrate. Although the size and exact shape of the test pad 70 and through hole 78 do not affect the self centring feature of the generally U-shaped portion 72, 74, 76 of the solder pad in cooperation with component leads, the dimensions of the extension 70 and hole 78 are, of course, limited by process parameters used in the manufacture of the printed circuit substrate as well as the parameters of the test apparatus contemplated for use therewith.

## Claims

1. A method of attaching leaded surface mountable components to surface solder pads on a printed circuit substrate comprising

   metalising the solder pads;

   depositing solder on the metalised solder pads;

   placing the components on the solder;

   reflowing the solder;

   characterised in that the metalising step comprises

   dividing each solder pad into a plurality of sections;

   metalising non-adjacent ones of said sections or enabling self alignment of the components to the solder pads during the reflowing step.

2. A method as claimed in claim 1, wherein the dividing step includes dividing each solder pad into three sections.

3. A method as claimed in claim 2 wherein the metalising step comprises metalising non-adjacent section of the solder pads for providing two metalised sections separated by one non-metalising section per component lead.

4. A method of attaching a surface mountable component lead to a surface solder pad on a printed circuit substrate comprising

   depositing solder on the solder pad in a pattern covering less than the whole solder pad;

   placing the component lead between the pattern deposited solder;

   and reflowing the deposited solder.

5. A method as claimed in claim 4 comprising a step of metalising each solder pad in a generally U-shaped pattern.

6. A method as claimed in claim 5 including the additional step of providing a through hole in the base of the U-shaped pattern.

7. A method as claimed in claim 3 or claim 5 wherein the depositing step includes using the width of the non-metalised section of each solder pad to aid in forming solder domes on the metalised sections.

8. A method as claimed in claim 7 wherein the depositing step includes metalising the solder pad in a pattern comprising two parallel metalised strips separated by an area of non-wettable material.

9. A method of attaching leaded surface mountable components to surface solder pads on a printed circuit substrate comprising

   metalising non-adjacent sections of each solder pad;

   and controlling the amount of solder deposited on each solder pad as a function of the geometry of the metalised sections of each solder pad.

10. A method as claimed in any preceding claim wherein the metalising step includes plating the non-adjacent sections with copper.

11. A method as claimed in any preceding claim wherein the depositing step includes passing the solder pads over a solder wave.

## Revendications

1. Méthode de fixation de composants pourvus de conducteurs et montables sur une surface à des pastilles de soudure de surface sur un substrat de circuit imprimé, comprenant :
   la métallisation des pastilles de soudure ;
   le dépôt de matière de soudage sur les pastilles de soudure métallisées ;
   le positionnement des composants sur la matière de soudage ;
   la reliquéfaction de la matière de soudage ; caractérisée en ce que l'opération de métallisation comprend :
   la division de chaque pastille de soudure en une pluralité de sections ; et
   la métallisation de sections non adjacentes parmi lesdites sections pour permettre l'auto-alignement des composants avec les pastilles de soudure pendant l'opération de reliquéfaction.

2. Méthode suivant la revendication 1, dans laquelle l'opération de division comprend la division de chaque pastille de soudure en trois sections.

3. Méthode suivant la revendication 2, dans laquelle l'opération de métallisation comprend la métallisation de sections non adjacentes des pastilles de soudure pour engendrer deux sections métallisées séparées par une section non métallisée, pour chaque conducteur de composant.

4. Méthode de fixation d'un conducteur de composant montable sur une surface à une pastille de soudure de surface sur un substrat de circuit imprimé, comprenant :

le dépôt de matière de soudage sur la pastille de soudure suivant une configuration recouvrant moins de la totalité de la pastille de soudure ;

le positionnement du conducteur de composant entre la matière de soudage déposée suivant ladite configuration ; et

la reliquéfaction de la matière de soudage déposée.

5. Méthode suivant la revendication 4, comprenant une opération de métallisation de chaque pastille de soudure suivant une configuration sensiblement en forme de U.

6. Méthode suivant la revendication 5, comprenant l'opération additionnelle d'exécution d'un trou traversant dans la base de la configuration en forme de U;

7. Méthode suivant la revendication 3 ou la revendication 5, dans laquelle l'opération de dépôt comprend l'utilisation de la largeur de la section non métallisée de chaque pastille de soudure pour aider à former des dômes de matière de soudage sur les sections métallisées.

8. Méthode suivant la revendication 4, dans laquelle l'opération de dépôt comprend la métallisation de la pastille de soudure suivant une configuration comprenant deux bandes métallisées parallèles séparées par une région de matière non mouillable.

9. Méthode de fixation de composants pourvus de conducteurs et montables sur une surface à des pastilles de soudure de surface sur un substrat de circuit imprimé, comprenant :

la métallisation de sections non adjacentes de chaque pastille de soudure ; et

le réglage de la quantité de matière de soudage déposée sur chaque pastille de soudure en fonction de la géométrie des sections métallisées de chaque pastille de soudure.

10. Méthode suivant l'une quelconque des revendications précédentes, dans laquelle l'opération de métallisation comprend le dépôt de cuivre sur les sections non adjacentes.

11. Méthode suivant l'une quelconque des revendications précédentes, dans laquelle l'opération de dépôt comprend le passage des pastilles de soudure sur une onde de matière de soudage.

**Ansprüche**

1. Verfahren zum Anbringen mit Anschlüssen versehener, oberflächenmontierbarer Komponenten auf Oberflächen-Lötanschlußflächen auf einem Träger mit einer gedruckten Schaltung, das umfaßt:

Metallisieren der Lötanschlußflächen, Aufbringen eines Lotes auf die metallisierten Lötanschlüsse,

Anordnen der Komponenten auf dem Lot,

Aufschmelzen des Lotes,

dadurch gekennzeichnet, daß der Schritt zum Metallisieren umfaßt:

Aufteilen jedes Lötanschlusses in eine Mehrzahl von Abschnitten,

Metallisieren von nichtbenachbarten der Abschnitte, um ein Selbstausrichten der Komponenten mit den Lötanschlüssen während des Schrittes zum Aufschmelzen zu ermöglichen.

2. Verfahren nach Anspruch 1, bei welchem der Schritt zum Aufteilen das Aufteilen jedes Lötanschlusses in drei Abschnitte umfaßt.

3. Verfahren nach Anspruch 2, bei welchem der Schritt zum Metallisieren das Metallisieren eines nichtbenachbarten Abschnittes der Lötanschlüsse zum Bereitstellen zweier metallisierter Abschnitte umfaßt, die durch einen nichtmetallisierten Abschnitt pro Komponentenanschluß getrennt sind.

4. Verfahren zum Anbringen eines Anschlusses einer oberflächenmontierbaren Komponente auf einem Oberflächen-Lötanschluß auf einem Träger mit einer gedruckten Schaltung, das umfaßt:

Aufbringen eines Lotes auf den Lötanschluß in einer Gestalt, die weniger als den den ganzen Lötanschluß überdeckt,

Anordnen des Komponenten-Anschlusses zwischen dem in einer Gestalt aufgebrachten Lot,

und Aufschmelzen des aufgebrachten Lotes.

5. Verfahren nach Anspruch 4, das einen Schritt zum Metallisieren jedes Lötanschlusses in einer im wesentlichen U-förmigen Gestalt umfaßt.

6. Verfahren nach Anspruch 5, welches den zusätzlichen Schritt zum Schaffen einer Durchgangsöffnung in der Basis der U-förmigen Gestalt umfaßt.

7. Verfahren nach Anspruch 3 oder 5, bei welchem der Schritt zum Aufbringen das Verwenden der Breite des nichtmetallisierten Abschnittes jedes Lötanschlusses zum Unterstützen des Ausbildens von Lötwölbungen auf den metallisierten Abschnitten umfaßt.

8. Verfahren nach Anspruch 4, bei welchem der Schritt zum Aufbringen das Metallisieren des Lötanschlusses in einer Gestalt umfaßt, die zwei parallele, metallisierte Streifen aufweist, die durch einen Bereich aus nichtbenetzbarem Material getrennt sind.

9. Verfahren zum Anbringen mit Anschlüssen versehener, oberflächenmontierbarer Komponenten auf Oberflächen-Lötanschlüssen auf einem Träger mit einer gedruckten Schaltung, das umfaßt:

Metallisieren nichtbenachbarter Abschnitte jedes Lötanschlusses,

und Steuern der auf jedem Lötanschluß aufgebrachten Lotmenge in Abhängigkeit von der Geometrie der metallsierten Abschnitte jedes Lötanschlusses.

10. Verfahren nach irgendeinem vorgehenden Anspruch, bei welchem der Schritt zum Metallisieren das Überziehen der nichtbenachbarten Abschnitte mit Kupfer umfaßt.

11. Verfahren nach irgendeinem vorgehenden Anspruch, bei welchem der Schritt zum Aufbringen das Überführen der Lötanschlüsse über einem Lotschwall umfaßt.

FIG. 1

FIG. 2

FIG. 3

FIG. 4

FIG. 5

FIG. 6

FIG. 7

8